# EUROPÄISCHE PATENTSCHRIFT

(11) **EP 0 509 349 B1**
(45) Veröffentlichungstag und Bekanntmachung des Hinweises auf die Patenterteilung: **26.06.1996**
(21) Anmeldenummer: 92105817.8
(22) Anmeldetag: 03.04.1992
(51) Int. Cl.: H03K 19/0175, H03K 19/00, H03K 19/003

(54) **Signalpegelwandler**
Signal level converter
Convertisseur de niveau de signal

(30) Priorität: 15.04.1991 DE 4112310
(43) Veröffentlichungstag der Anmeldung: 21.10.1992
(73) Patentinhaber: SIEMENS AKTIENGESELLSCHAFT, D-80333 München (DE)
(72) Erfinder: Barré, Claude, Dipl.-Ing., W-8000 München 70 (DE)

(56) Entgegenhaltungen:
- EP-A- 0 208 397
- EP-A- 0 232 969
- EP-A- 0 326 947
- FR-A- 2 519 211
- US-A- 4 999 519
- US-A- 5 023 479
- IBM TECHNICAL DISCLOSURE BULLETIN. Bd. 33, Nr. 10B, März 1991, NEW YORK US Seiten 388 - 389 'Bicmos emitter-coupled logic converter for extended voltage operation'

## Beschreibung

Die Erfindung betrifft einen Signalpegelwandler zur Umsetzung von CMOS-Eingangssignalpegeln auf ECL-Ausgangssignalpegel mit den folgenden Merkmalen:
- von zwei emittergekoppelten Transistoren ist der Kollektor des ersten Transistors unmittelbar und der Kollektor des zweiten Transistors über einen Widerstand an ein erstes Versorgungsspannungspotential angeschlossen,
- die Emitter der ersten beiden Transistoren sind mit dem Kollektor eines dritten Transistors verbunden, der über einen emitterseitigen Widerstand an ein zweites Versorgungsspannungspotential angeschlossen ist,
- die Basisanschlüsse des zweiten und dritten Transistors sind mit einem Bezugs- bzw. Steuerpotential verbunden,
- ein vierter Transistors ist mit seiner Basis an den Kollektor des zweiten Transistors und mit seinem Kollektor an das erste Versorgungsspannungspotential geschaltet,
- ein Eingangssignalanschluß ist mit der Basis des ersten Transistors und ein Ausgangssignalanschluß mit dem Emitter des vierten Transistors verbunden,
- der kollektorseitige Widerstand des zweiten Transistors ist als ein erster steuerbarer Widerstand ausgebildet und wird so gesteuert, daß sein Widerstand hoch ist, wenn der durch die Kollektor-Emitter-Strecke des dritten Transistors fließende Strom durch die Kollektor-Emitter-Strecke des zweiten Transistors fließt, und sein Widerstand niedrig ist, wenn dieser Strom durch die Kollektor-Emitter-Strecke des ersten Transistors fließt.

Ein derartiger Signalpegelwandler ist beispielsweise aus der US-P 4 999 519 bekannt.

Bei der Realisierung von digitalen elektronischen Systemen werden üblicherweise schnelle Logikschaltstufen in der verlustleistungsintensiven bipolaren Stromschalterschaltungstechnik (ECL) und weniger schnelle Schaltstufen in der verlustleistungsarmen komplementären MOS-Schaltungstechnik (CMOS) realisiert. Da beide Schaltungstechniken unterschiedliche Spannungspegel für die logischen Signale L und H verwenden, müssen beim Übergang von CMOS- zu ECL-Schalterstufen Signalpegelwandler eingesetzt werden. In der Regel werden die CMOS- und ECL-Schalterstufen auf jeweils verschiedenen ICs realisiert, die auf Leiterplatten angeordnet sind und über Leiterbahnen miteinander verbunden sind.

Wegen des geringeren Signalpegelhubs und der Möglichkeit, den Ausgang des Signalpegelwandlers an den Wellenwiderstand der Leiterbahnen anzupassen, sind ECL-Signalpegel besser als CMOS-Signalpegel für die Signalübertragung auf der Leiterplatte geeignet. Es empfiehlt sich also, den Signalpegelwandler auf demjenigen IC anzuordnen, das die CMOS-Schaltstufen enthält.

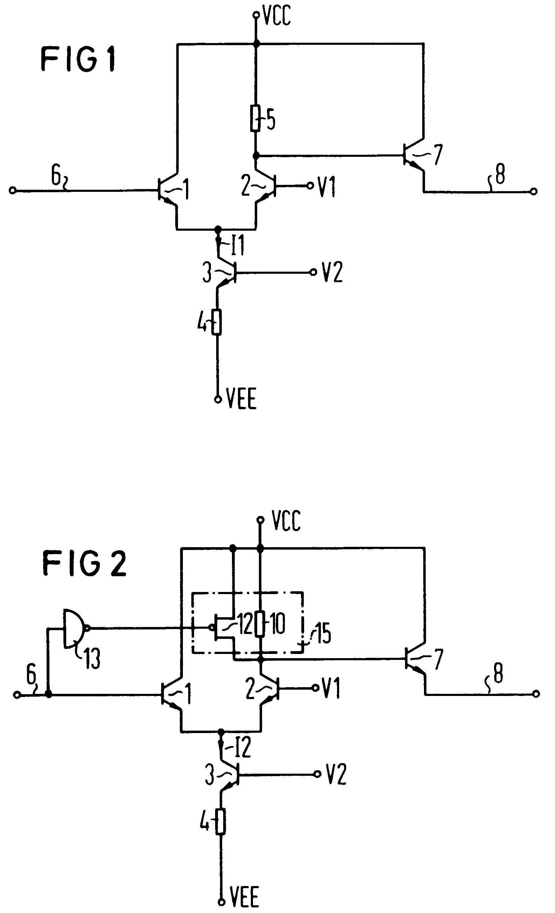

Ein bekannter Signalpegelwandler ist in Figur 1 gezeigt. Er kann mit Hilfe der BiCMOS-Technologie, bei der MOS- und bipolare Transistoren auf einem IC angeordnet werden können, realisiert werden. Die Emitter von zwei emittergekoppelten Transistoren 1, 2 werden über eine Stromquelle, die aus dem Transistor 3 und dem Widerstand 4 besteht, an ein Versorgungspotential VEE angeschlossen. Die Stromquelle prägt den Strom I1 ein. Der Kollektor des Transistors 1 liegt direkt, der Kollektor des Transistors 2 über einen Widerstand 5 an einem weiteren Versorgungspotential VCC. Die Basis des Transistors 2 wird mit einem Referenzpotential V1, das in der Mitte der Potentiale VCC, VEE liegt, verbunden. Der Eingangssignalanschluß 6 des Pegelumsetzers ist mit der Basis des Transistors 1 verbunden. Die Signalpegel für das Eingangssignal liegen für H und L beim Wert der Potentiale VCC bzw. VEE (z.B. 0V und -5V). Die Basis eines weiteren Transistors 7, der als Emitterfolger arbeitet, ist mit dem Kollektor des Transistors 2 verbunden. Der Emitter des Transistors 7 bildet den Ausgangssignalanschluß 8. Die ECL-Signalpegel für das Ausgangssignal liegen z.B. bei -0,9V für H und -1,7V für L.

Bei einem H-Signal am Schaltungseingang 6 fließt der Strom I1 durch den Transistor 1, bei einem L-Signal durch den Transistor 2. Wenn das Eingangssignal auf H-Potential liegt, ergibt sich folgendes: Einerseits muß der Basisstrom des Transistors 7 so bemessen sein, daß die Stromstärke am Ausgang 8 20mA bis 25mA beträgt. Dies entspricht dem üblichen Wert für eine Leiterplatte mit 50 Ohm Wellenwiderstand. Andererseits müssen der Spannungsabfall am Widerstand 5, den der Basisstrom des Transistors 7 hervorruft, und der Spannungsabfall an der Basis-Emitter-Strecke des Transistors 7 einen Wert von -0,9V ergeben. Dadurch wird für den Widerstand 5 einen Maximalwert von z.B. 200 Ohm festgelegt.

Wenn das Eingangssignal auf L-Potential liegt, fließt zusätzlich der Strom I1 durch den Widerstand 5. Der Strom I1 muß so gewählt werden, daß ein Pegelhub von -0,9V auf -1,7V am Kollektor von Transistor 2 entsteht. Da der Widerstand 5 den Maximalwert (z.B. 200 Ohm) nicht überschreiten darf, kann der Strom I1 nicht unter einem Minimalwert von z.B. 4mA liegen. Die minimale Verlustleistung des Signalpegelwandlers wird im wesentlichen vom Strom I2 bestimmt und ist relativ hoch.

Bei dem gattungsgemäßen Signalpegelwandler wird demgegenüber eine Verbesserung dadurch erzielt, daß der kollektorseitige Widerstand des zweiten Transistors als ein erster steuerbarer Widerstand ausgebildet ist und so gesteuert wird, daß sein Widerstand hoch ist, wenn der durch die Kollektor-Emitter-Strecke des dritten Transistors fließende Strom durch die Kollektor-Emitter-Strecke des zweiten Transistors fließt, und sein Widerstand niedrig ist, wenn dieser Strom durch die Kollektor-Emitter-Strecke des ersten Transistors fließt.

Aufgabe der vorliegenden Erfindung ist es, einen Signalpegelwandler nach dem Oberbegriff des Patentanspruchs 1 so weiterzubilden, daß die Verlustleistung weiter erniedrigt wird.

Gelöst wird diese Aufgabe dadurch, daß
- ein fünfter Transistor mit seinem Kollektor an die Basis des vierten Transistors und mit seinem Emitter über einen zweiten steuerbaren Widerstand an das zweite Versorgungsspannungspotential und mit seiner Basis an ein weiteres Steuerpotential angeschlossen ist und
- der zweite steuerbare Widerstand gleichsinnig zum ersten steuerbaren Widerstand gesteuert wird.

Anhand der Figuren 2 bis 4 der Zeichnung werden im folgenden mehrere Ausführungsbeispiele erläutert. Es zeigen
Figur 1 einen Signalpegelwandler nach dem Stand der Technik,
Figur 2 einen weitergebildeten Signalpegelwandler mit geringer Verlustleistung,
Figur 3 einen gemäß der Erfindung weitergebildeten Signalpegelwandler mit geringer Verlustleistung und mit von der Temperatur unabhängigen Ausgangssignalpegeln und
FIG 4 einen solchen Sianalpegelwandler mit zusätzlicher Kompensation der Streuung der herstellungsabhängigen Parameter von MOS-Transistoren.

FIG 2 zeigt einen Signalpegelwandler mit geringer Verlustleistung zur Umsetzung von CMOS-Eingangssignalpegeln auf ECL-Ausganossignalpegel. Im Kollektorkreis des Transistors 2 ist ein steuerbarer Widerstand 15 vorhanden. Er besteht aus der Parallelschaltung eines ohmschen Widerstandes 10 und der Drain-Source-Strecke eines PMOS-Transistors 12. Die Gate-Elektrode des Transistors 12 ist über einen Inverter 13 mit dem Eingangssignalanschluß 6 verbunden.

Bei einem L-Potential am Signaleingang 6 ist der PMOS-Transistor 12 gesperrt. Der Widerstandswert der Parallelschaltunq 15 ist nun gleich dem Wert des Widerstandes 10. Der Pegelhub für den L-Pegel am Ausgang 8 von z.B. -0.9V auf -1,7V wird durch den Spannungsabfall am Widerstand 10 bewirkt, den der Strom I2 hervorruft. Der Wert des Widerstandes 10 wird höher gewählt als der Wert des Widerstandes 5 aus FIG 1. Der Strom I2 kann deshalb niedriger gewählt werden als der Strom I1 aus FTG 1. Die Verlustleistung wird somit verringert.

Bei einem H-Potential am Signaleingang 6 ist der PMOS-Transistor 10 leitend. Er wird so dimensioniert, daß sich für den Widerstandswert der Parallelschaltung 15 z.B. 200 Ohm ergibt. Dieser Wert ist für die Anpassung des Signalausgangs 8 an den Wellenwiderstand der Leiterbahn notwendig, wie im Zusammenhang mit FIG 1 beschrieben wurde.

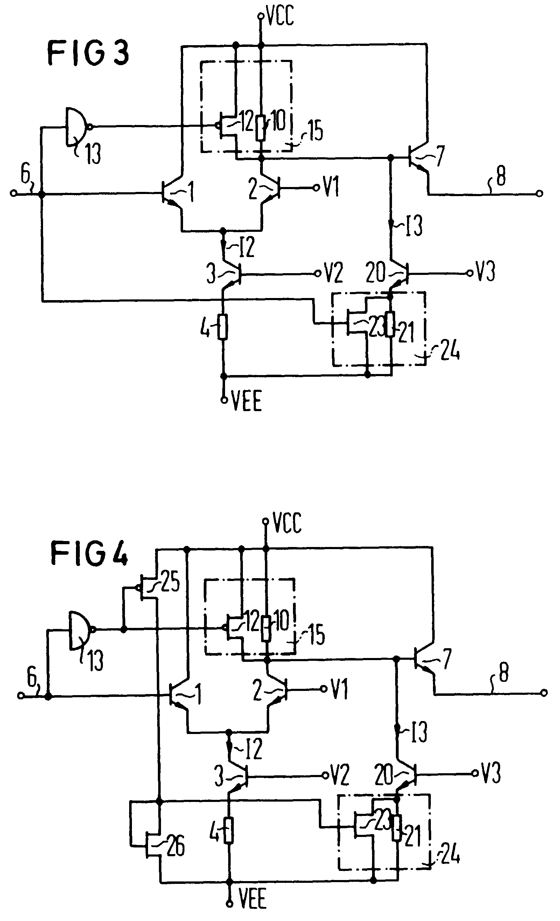

Der Spannungsabfall an der Basis-Emitter-Strecke des Transistors 7 fällt mit steigender Temoeratur. Somit steigt der H- bzw. L-Pegel am Ausgang 8 entsprechend an. In FIG 3 wird zur Temperaturkompensation eine Stromquelle zwischen der Basis des Emitterfolgertransistors 7 und dem Potential VEE angeordnet. Sie besteht aus dem Transistor 20 und einem emitterseitig angeordneten steuerbaren Widerstand 24. Die Basis des Transistors ist an ein Steuerpotential V3 gelegt. Der steuerbare Widerstand besteht aus einem ohmschen Widerstand 21 und einem NMOS-Transistor 23, dessen Gate-Elektrode mit dem Eingangssignalanschluß 6 verbunden ist.

Die Temperaturabhängigkeit des Steuerpotentials V3 und des Spannungsabfalls an der Basis-Emitter-Strecke des Transistors 20 ist in bereits bekannter Weise so eingestellt, daß der Strom I3 mit steigender Temperatur ansteigt. Er bewirkt am steuerbaren Widerstand 15 einen zusätzlichen Spannungsabfall, der den temperaturbedingten Anstieg der Pegel am Ausgang 8 ausgleicht. Der zusätzliche Spannungsabfall soll für H- und L-Pegel gleich groß sein. Somit muß der Strom 13 bei niedrigem Widerstandswert des gesteuerten Widerstandes 15 hoch, bei hohem Widerstandswert niedrig sein. Dies läßt sich dadurch erreichen, daß das Verhältnis der Widerstandswerte der beiden gesteuerten Widerstände 15 und 24 für den H- bzw. L-Pegel annähernd gleich bleibt. Hierzu dient der NMOS-Transistor 23: Bei L-Pegel am Signaleingang 6 ist er gesperrt, während er bei H-Pegel leitet und den Gesamtwiderstand der Parallelschaltung 24 erniedrigt.

Bei der Herstellung von ICs tritt das Problem der Toleranzen der Bauelementeparameter auf. Bei gleichartigen und gleich dimensionierten Bauelementen wie beispielsweise den Widerständen 10 und 12 läßt sich ein annähernd gleiches Verhältnis der elektrischen Parameter einhalten. Bei MOS-Transistoren unterschiedlicher Polarität, wie z.B. dem NMOS-Transistor 23 und dem PMOS-Transistor 12 trifft dies in der Regel nicht mehr zu.

Um die herstellungsabhängige Parameterstreuung dieser beiden MOS-Transistoren unterschiedlicher Polarität ebenfalls zu kompensieren, dient die Schaltungsanordnung in FIG 4. Zwischen die Versorgungsspannungspotentiale VCC, VEE wird eine Serienschaltung aus jeweils einem PMOS-Transistor 25 und einem NMOS-Transistor 26 angeordnet. Die Gate-Elektrode des Transistors 25 ist mit dem invertierten Eingangssignalanschluß 6 verbunden. Der Transistor 26 ist als Widerstand geschaltet, indem seine Gate- und Drain-Elektrode verbunden sind. Der Gate-Anschluß des Transistors 23 ist ebenfalls an die Drain-Elektrode des Transistors 26 gelegt.

Herstellungsbedingt falle beispielsweise der Widerstand der Drain-Source-Strecke des PMOS-Transistors 12 höher, und der Widerstand der Drain-Source-Strecke des NMOS-Transistors 23 niedriger aus als vorgesehen. Das Entsprechende ergibt sich dann für die Drain-Source-Strecken der Transistoren 25 bzw. 26. Für einen H-Pegel am Eingang 6, wenn also die Transistoren 12, 23, 25 leitend sind. ergibt sich: Der Stromfluß durch die Drain-Source-Strecken der Transistoren 25 und 26 ruft am Transistor 26 einen Spannungsabfall hervor. Aufgrund des geringeren Widerstandswertes der Drain-Source-Strecke des Transistors 26 wird der Spannungsabfall geringer sein als der vorgesehene Wert. Durch das niedrigere Gate-Potential des Transistors 23 wird der Widerstand seiner Drain-Source-Strecke erhöht. Somit wird das Verhältnis der Widerstände der Drain-Source-Strecken der Transistoren 12, 23 wieder ausgeglichen. Das Entsprechende ergibt sich für den Fall des umgekehrten Verhältnisses der Widerstände der Drain-Source-Strecken der Transistoren 12, 25 bzw. 23. 26.

## Patentansprüche

1. Signalpegelwandler zur Umsetzung von CMOS-Eingangssignalpegeln auf ECL-Ausgangssignalpegel mit den Merkmalen:
- von zwei emittergekoppelten Transistoren (1, 2) ist der Kollektor des ersten Transistors unmittelbar und der Kollektor des zweiten Transistors über einen Widerstand an ein erstes Versorgungsspannungspotential (VCC) angeschlossen,
- die Emitter der ersten beiden Transistoren (1, 2) sind mit dem Kollektor eines dritten Transistors (3) verbunden, der über einen emitterseitigen Widerstand (4) an ein zweites Versorgungsspannungspotential (VEE) angeschlossen ist,
- die Basisanschlüsse des zweiten und dritten Transistors (2, 3) sind mit einem Bezugs- bzw. Steuerpotential (V1 bzw. V2) verbunden,
- ein vierter Transistor (7) ist mit seiner Basis an den Kollektor des zweiten Transistors (2) und mit seinem Kollektor an das erste Versorgungsspannungspotential (VCC) geschaltet,
- ein Eingangssignalanschluß (6)ist mit der Basis des ersten Transistors (1) und ein Ausgangssignalanschluß (8) mit dem Emitter des vierten Transistors (7) verbunden,
- der kollektorseitige Widerstand des zweiten Transistors (2) ist als ein erster steuerbarer Widerstand (15) ausgebildet und wird so gesteuert, daß sein Widerstand hoch ist, wenn der durch die Kollektor-Emitter-Strecke des dritten Transistors (3) fließende Strom durch die Kollektor-Emitter-Strecke des zweiten Transistors (2) fließt, und sein Widerstand niedrig ist, wenn dieser Strom durch die Kollektor-Emitter-Strecke des ersten Transistors (1) fließt,
**dadurch gekennzeichnet**, daß
- ein fünfter Transistor (20) mit seinem Kollektor an die Basis des vierten Transistors (7) und mit seinem Emitter über einen zweiten steuerbaren Widerstand (24) an das zweite Versorgungsspannungspotential (VEE) und mit seiner Basis an ein weiteres Steuerpotential (V3) angeschlossen ist und
- der zweite steuerbare Widerstand (24) gleichsinnig zum ersten steuerbaren Widerstand (15) gesteuert wird.

2. Signalpegelwandler nach Anspruch 1,
**dadurch gekennzeichnet**, daß der erste steuerbare Widerstand (15) als eine Parallelschaltung aus einem ersten ohmschen Widerstand (10) und der Drain-Source-Strecke eines ersten MOS-Transistors (12) ausgebildet ist, dessen Gate-Elektrode über einen Inverter (13) mit dem Eingangssignalanschluß (6) verbunden ist.

3. Signalpegelwandler nach Anspruch 1,
**dadurch gekennzeichnet**, daß der zweite steuerbare Widerstand (24) als eine Parallelschaltung aus einem zweiten ohmschen Widerstand (21) und der Drain-Source-Strecke eines zweiten MOS-Transistors (23) ausgebildet ist, dessen Gate-Elektrode mit dem Eingangssignalanschluß (6) verbunden ist.

4. Signalpegelwandler nach Anspruch 2,
**dadurch gekennzeichnet**, daß
- der zweite steuerbare Widerstand (24) als eine Parallelschaltung aus einem zweiten ohmschen Widerstand (21) und der Drain-Source-Strecke eines zweiten MOS-Transistors (23) ausgebildet ist,
- eine Serienschaltung aus den Drain-Source-Strecken eines dritten und vierten MOS-Transistors (25, 26) vorhanden ist,
- der Source-Anschluß des dritten MOS-Transistors (25) mit dem ersten Versorgungsspannungspotential (VCC) und der Source-Anschluß des vierten MOS-Transistors (26) mit dem zweiten Versorgungsspannungspotential (VEE) verbunden ist,
- die Gate-Elektrode des ersten MOS-Transistors (12) mit der Gate-Elektrode des dritten MOS-Transistors (25) verbunden ist,
- die Gate-Elektrode des zweite MOS-Transistors (23) mit dem Verbindungspunkt zwischen dem dritten und vierten MOS-Transistor (25, 26) verbunden ist und
- die Gate- und Drain-Elektrode des vierten MOS-Transistors (26) miteinander verbunden sind.

5. Signalpegelwandler nach einem der Ansprüche 1 bis 4,
**dadurch gekennzeichnet**, daß
- der erste und der zweite MOS-Transistor (12, 23) entgegengesetzte Polarität besitzen,
- der dritte und vierte MOS-Transistor (25, 26) gleiche Polarität wie der erste bzw. der zweite MOS-Transistor (12, 23) besitzen.

## Claims

1. Signal level converter for converting CMOS input signal levels to ECL output signal levels, having the features:
- the collector of the first transistor of two emitter-coupled transistors (1, 2) is connected directly to a first supply voltage potential (VCC), and the collector of the second transistor is connected via a resistor to the first supply voltage potential (VCC),
- the emitters of the first two transistors (1, 2) are connected to the collector of a third transistor (3), which is connected to a second supply voltage potential (VEE) via an emitter-side resistor (4),
- the base terminals of the second and third transistors (2, 3) are connected to a reference potential (V1) and a control potential (V2), respectively,
- the base of a fourth transistor (7) is connected to the collector of the second transistor (2), and the collector of the said fourth transistor (7) is connected to the first supply voltage potential (VCC),
- an input signal terminal (6) is connected to the base of the first transistor (1), and an output signal terminal (8) is connected to the emitter of the fourth transistor (7),
- the collector-side resistor of the second transistor (2) is designed as a first controllable resistor (15) and is controlled in such a way that its resistance is high when the current flowing through the collector-emitter path of the third transistor (3) flows through the collector-emitter path of the second transistor (2), and its resistance is low when this current flows through the collector-emitter path of the first transistor (1),
characterized in that
- the collector of a fifth transistor (20) is connected to the base of the fourth transistor (7), and the emitter of the said fifth transistor (20) is connected via a second controllable resistor (24) to the second supply voltage potential (VEE), and the base of the said fifth transistor (20) is connected to a further control potential (V3), and
- the second controllable resistor (24) is controlled in the same sense as the first controllable resistor (15).

2. Signal level converter according to Claim 1,
characterized in that the first controllable resistor (15) is designed as a parallel circuit formed by a first non-reactive resistor (10) and the drain-source path of a first MOS transistor (12), the gate electrode of which is connected to the input signal terminal (6) via an invertor (13).

3. Signal level converter according to Claim 1,
characterized in that the second controllable resistor (24) is designed as a parallel circuit formed by a second non-reactive resistor (21) and the drain-source path of a second MOS transistor (23), the gate electrode of which is connected to the input signal terminal (6).

4. Signal level converter according to Claim 2,
characterized in that
- the second controllable resistor (24) is designed as a parallel circuit formed by a second non-reactive resistor (21) and the drain-source path of a second MOS transistor (23),
- a series circuit formed by the drain-source paths of a third and a fourth MOS transistor (25, 26) is provided,
- the source terminal of the third MOS transistor (25) is connected to the first supply voltage potential (VCC), and the source terminal of the fourth MOS transistor (26) is connected to the second supply voltage potential (VEE),
- the gate electrode of the first MOS transistor (12) is connected to the gate electrode of the third MOS transistor (25),
- the gate electrode of the second MOS transistor (23) is connected to the junction point between the third and fourth MOS transistors (25, 26), and
- the gate and drain electrodes of the fourth MOS transistor (26) are connected to one another.

5. Signal level converter according to one of Claims 1 to 4,
characterized in that
- the first and second MOS transistors (12, 23) have opposite polarities,
- the third and fourth MOS transistors (25, 26) have the same polarities as the first and second MOS transistors (12, 23), respectively.

## Revendications

1. Convertisseur de niveaux d'un signal d'entrée CMOS en un niveau de signal de sortie ECL présentant les caractéristiques suivantes :
- parmi deux transistors (1, 2) à émetteurs couplés, le collecteur du premier transistor est connecté directement et le collecteur du second transistor est connecté par l'intermédiaire d'une résistance à un premier potentiel (VCC) de tension d'alimentation,
- les émetteurs des deux premiers transistors (1, 2) sont reliés au collecteur d'un troisième transistor (3), qui est connecté par l'intermédiaire d'une résistance (4) du côté émetteur à un second potentiel (VEE) de tension d'alimentation,
- les bornes de base des second et troisième transistors (2, 3) sont reliées à des potentiels (V1 et V2) de référence et de commande,
- un quatrième transistor (7) est branché par sa base au collecteur du second transistor (2) et par son collecteur au premier potentiel (VCC) de tension d'alimentation,
- une borne (6) de signal d'entrée est reliée à la base du premier transistor (1) et une borne (8) de signal de sortie est reliée à l'émetteur du quatrième transistor (7),
- la résistance du côté collecteur du second transistor (2) est sous la forme d'une première résistance (15) pouvant être commandée et est commandée de telle sorte que sarésistance soit grande, lorsque le courant passant par la section collecteur-émetteur du troisième transistor (3) passe par la section collecteur-émetteur du second transistor (2) et que sa résistance soit petite, lorsque ce courant passe par la section collecteur-émetteur du premier transistor (1),
caractérisé en ce que
- un cinquième transistor (20) est connecté par son collecteur à la base du quatrième transistor (7), par son émetteur par l'intermédiaire d'une seconde résistance (24) pouvant être commandée au second potentiel (VEE) de tension d'alimentation et par sa base à un autre potentiel (V3) de commande et
- la seconde résistance (24) pouvant être commandée est commandée dans le même sens que la première résistance (15) pouvant être commandée.

2. Convertisseur de niveaux d'un signal suivant la revendication 1,
caractérisé en ce que la première résistance (15) pouvant être commandée est sous forme d'un circuit parallèle constitué d'une première résistance ohmique (10) et de la section drain-source d'un premier transistor (12) MOS, dont l'électrode de grille est reliée par l'intermédiaire d'un inverseur (13) à la borne (6) de signal d'entrée.

3. Convertisseur de niveaux d'un signal suivant la revendication 1,
caractérisé en ce que la seconde résistance (24) pouvant être commandée est sous la forme d'un circuit parallèle constitué d'une seconde résistance ohmique (21) et de la section drain-source d'un second transistor (23) MOS, dont l'électrode de grille est reliée à la borne (6) de signal d'entrée.

4. Convertisseur de niveaux d'un signal suivant la revendication 2,
caractérisé en ce que
- la seconde résistance (24) pouvant être commandée est sous la forme d'un circuit parallèle constitué d'une seconde résistance ohmique (21) et de la section drain-source d'un second transistor MOS (23),
- il est prévu un circuit-série constitué des sections drain-source de troisième et quatrième transistors MOS (25, 26),
- la borne de source du troisième transistor MOS (25) est reliée au premier potentiel (VCC) de tension d'alimentation et la borne de source du quatrième transistor MOS (26) est reliée au second potentiel (VEE) de tension d'alimentation,
- l'électrode de grille du premier transistor MOS (12) est reliée à l'électrode de grille du troisième transistor MOS (25),
- l'électrode de grille du second transistor MOS (23) est reliée au point de liaison entre les troisième et quatrième transistor MOS (25, 26) et
- les électrodes de grille et de drain du quatrième transistor MOS (26) sont reliées l'une à l'autre.

5. Convertisseur de niveaux d'un signal suivant l'une des revendications 1 à 4,
caractérisé en ce que
- les premier et second transistors MOS (12, 23) sont de polarité opposée,
- les troisième et quatrième transistors MOS (25, 26) sont de même polarité que le premier ou le second transistor MOS (12, 23).
